# EUROPÄISCHE PATENTSCHRIFT

(11) **EP 3 210 444 B1**
(45) Veröffentlichungstag und Bekanntmachung des Hinweises auf die Patenterteilung: **21.11.2018**
(21) Anmeldenummer: 15793672.5
(22) Anmeldetag: 14.09.2015
(51) Int. Cl.: H05K 1/18, B60Q 1/26, F21S 43/14, F21S 43/19, F21S 43/20, H05K 1/02, H05K 3/00, H05K 3/12, H05K 3/28, H05K 3/32

(54) **KRAFTFAHRZEUG-AUSSENLEUCHTE**
MOTOR VEHICLE EXTERIOR LIGHT
APPAREIL D'ÉCLAIRAGE EXTÉRIEUR POUR VÉHICULE AUTOMOBILE

(30) Priorität: 15.09.2014 AT 506422014
(43) Veröffentlichungstag der Anmeldung: 30.08.2017
(73) Patentinhaber: SCIO Holding GmbH, 4030 Linz (AT)
(72) Erfinder: HEILMANN, Michael, 4616 Weisskirchen (AT); IDE, Dirk, 4040 Linz (AT); PADINGER, Franz, 4502 St. Marien (AT)
(74) Vertreter: Jell, Friedrich
(86) Internationale Anmeldenummer: PCT/AT2015/050226
(87) Internationale Veröffentlichungsnummer: WO 2016/040972

(56) Entgegenhaltungen:
- EP-A1- 2 048 918
- EP-A2- 1 071 142
- EP-A2- 1 655 174
- DE-U1-202012 103 902
- US-A- 5 038 255
- US-A1- 2010 277 931
- US-A1- 2013 015 478

## Beschreibung

Die Erfindung betrifft eine Kraftfahrzeug-Außenleuchte.

An Außenleuchten wie sie bei Kraftfahrzeugen verwendet werden, ist eine Vielzahl von sich teilweise entgegenstehenden Anforderungen gestellt. Gewünscht bzw. gefordert ist eine möglichst hohe Lichtausbeute bzw. Lichtabgabe. Dieses hohe Lichtabgabevermögen soll aber in einer möglichst kompakten Baueinheit Platz finden, welche Baueinheit zusätzlich den Beanspruchungen in einem Kraftfahrzeug gewachsen ist. Insbesondere muss die Baueinheit beim bestimmungsgemäßen Einsatz großen Temperaturschwankungen und starken Erschütterungen und allfälligen Witterungseinflüssen, beispielsweise Schwallwasser, gewachsen sein. Im Hinblick auf den bestehenden massiven Kostendruck im Kraftfahrzeugbau soll eine Kraftfahrzeug-Außenleuchte ferner besonders kostengünstig ausgeführt sein.

Aus der historischen Entwicklung von Kraftfahrzeug-Außenleuchten kennt man Systeme, bei denen eine Glühlampe, zumeist eine Halogenglühlampe, in einer Aufnahmevorrichtung aufgenommen wurde, welche Aufnahmevorrichtung auf der Seite der Glühwendel als Reflektor bzw. als Lichtformelement ausgebildet war. Bei bekannten Systemen wurde stets versucht, die Glühwendel und damit den lichtabgebenden Bereich einer Lampe so klein als möglich zu halten. Somit konnte bei der optischen Berechnung des Reflektors bzw. der Lichtlenkeinheit, von einer quasi punkförmigen Lichtquelle ausgegangen werden, was die Berechnung derartiger Lichtleitsysteme deutlich vereinfachte. Mit der Verwendung einer Xenon-Bogenlampe wurde das Ideal einer punktförmigen Lichtquelle bereits weitestgehend erreicht. Allerdings erfordert eine Xenon-Lampe zum Betrieb und zur Zündung des Lichtbogens einen beträchtlichen technischen Aufwand, was auch die Kosten deutlich steigerte.

Betrachtet man nun das gesamte System aus Abdeckscheibe, Lichtlenk- bzw. Reflektoreinheit, Leuchtmittel und abschließendes Gehäuse, so erreichen bekannte Kraftfahrzeug-Außenleuchten eine beträchtliche Größe, Komplexität, Gewicht und insbesondere auch Herstellungskosten.

Auch mit Einführung von Leuchtdioden als Leuchtmittel wurden bestehende Kraftfahrzeug-Außenleuchten dahingehend angepasst, dass bestehende Leuchtmittel durch eine oder mehrere Leuchtdioden ersetzt wurden, wobei der Reflektor bzw. die Lichtlenkeinheit an die Lichtabgabecharakteristik von Leuchtdioden angepasst wurde. Aufgrund der reduzierten Baugröße von Leuchtdioden, nimmt die Reflektor- und Lichtlenkeinheit weiterhin den weitaus größten Teil einer Kraftfahrzeug-Außenleuchte ein.

Relevanter Stand der Technik ist in den Patentschriften US 5 038 255 A, DE 20 2012 103902 U1 und EP 1 071 142 A2 offenbart.

Die Aufgabe der Erfindung liegt also darin eine Kraftfahrzeug-Außenleuchte zu schaffen, welche gegenüber dem Stand der Technik ein deutlich verringertes Volumen, ein wesentlich verringertes Gewicht und insbesondere einen deutlich vereinfachten Aufbau aufweist. Insbesondere ist die Kraftfahrzeug-Außenleuchte derart auszubilden, dass sich die Herstellung deutlich vereinfacht, insbesondere dass weniger Arbeitsschritte erforderlich sind.

Die Aufgabe der Erfindung wird gelöst durch eine Kraftfahrzeug-Außenleuchte nach Anspruch 1, umfassend eine Tragstruktur, eine Mehrzahl von Leuchtmittel und eine zumindest abschnittsweise lichtdurchlässige Abdeckscheibe. Die Leuchtmittel sind an der Tragstruktur angeordnet, ferner weist die Abdeckscheibe eine den Leuchtmittel zugewandte Innenseite auf. Die Tragstruktur ist durch ein elastisch rückstellbares Folienmaterial gebildet, wobei auf der Tragstruktur elektrisch leitfähige Strukturen angeordnet sind. Ferner sind die Leuchtmittel mittels eines aushärtbaren Verbindungsmaterials die elektrisch leitfähigen Strukturen kontaktierend, direkt auf der Tragstruktur angeordnet. Die Tragstruktur ist auf der Innenseite der Abdeckscheibe angeordnet.

Unter Kraftfahrzeug werden Fahrzeuge verstanden, welche sich im öffentlichen Straßenverkehr bewegen und die dementsprechenden Sicherheitsanforderungen an Sicht- und Erkennbarkeit für andere Straßenverkehrsteilnehmer erfüllen müssen. Beispielsweise und nicht abschließend sind dies Autos, Busse, Lastkraftwägen, Landwirtschaftliche Fahrzeuge und Krafträder. Unter Kraftfahrzeugen werden aber auch Fahrzeuge des nicht öffentlichen Verkehrs verstanden, beispielsweise Fahrzeuge im Grubenbau, Hoch- und Tiefbau, abseits des öffentlichen Verkehrsnetzes.

In einer Ausführung ist die Kraftfahrzeug-Außenleuchte zur Lichtabgabe in Richtung eines Abschnitts des Fahrwegs des Kraftfahrzeugs ausgebildet. Unter einem Abschnitt des Fahrwegs des Kraftfahrzeugs wird jener Bereich verstanden, der in Fahrtrichtung bzw. entgegen der Fahrtrichtung gerichtet ist. Somit kann die gegenständliche Kraftfahrzeug-Außenleuchte als Frontscheinwerfer oder als Rückleuchte eines Kraftfahrzeugs ausgebildet sein.

In einer weiteren Ausführung kann die Kraftfahrzeug-Außenleuchte auch als Rücklicht, Blinker, Seitenstrahler, Begrenzungslicht bspw. für LKW Aufleger, Warnleuchte bspw. zur Umrisserkennung von LKW Aufleger ausgebildet sein.

Die Verwendung eines elastisch rückstellbaren Folienmaterials als Tragstruktur hat den Vorteil, dass sich somit die Tragstruktur an die Form der Abdeckscheibe, insbesondere an die Wölbung derselben, anpassen kann, ohne dass es zu einer Beschädigung der Tragstruktur, der darauf angeordneten Leuchtmittel und der elektrisch leitfähigen Strukturen kommt.

Für einen Frontscheinwerfer wird die Abdeckscheibe im Wesentlichen durchgehend transparent sein. Bei einer Ausführung als Rückleuchte ist die Abgabe mehrere Lichtsignale vorgesehen, daher kann die Abdeckscheibe abschnittsweise eingefärbt sein - die Leuchtmittel geben in diesem Fall weißes Licht ab. Es ist jedoch auch möglich, dass die Abdeckscheibe transparent ist und die Leuchtmittel ihrer Funktion entsprechend, eingefärbtes Licht abgeben.

Dass die Leuchtmittel mittels eines aushärtbaren Verbindungsmaterials direkt auf der Tragstruktur angeordnet sind hat den besonderen Vorteil, dass dadurch keine Montagevorrichtung für die Leuchtmittel erforderlich ist und somit deutlich Platz eingespart werden kann. Zusätzlich reduziert der Wegfall einer Montagevorrichtung die Kosten je Kraftfahrzeug-Außenleuchte. Ebenfalls von Vorteil ist, dass elektrische Kontaktprobleme zwischen Leuchtmittel und Montagevorrichtung wegfallen.

Nach einer Weiterbildung ist vorgesehen dass das Folienmaterial durch eine Kunststofffolie gebildet ist, beispielsweise aus PET, PC, PMMA, ABS. Diese Kunststoffe haben den Vorteil, dass sie eine gute mechanische und chemische Langzeitstabilität haben. Dies ist insbesondere von Vorteil, da beim bestimmungsgemäßen Einsatz in einem Kraftfahrzeug ein großer Temperaturbereich auftreten wird und ferner mit starken Erschütterungen zu rechnen ist. Diese Belastungen muss die Tragstruktur über den erwarteten Einsatzzeitraum ohne Einschränkung der Tragfähigkeit überstehen können. Zur Erzielung spezifischer mechanischer Eigenschaften kann das Folienmaterial auch als Verbundmaterial bzw. Laminat mehrerer Kunststoffe, mit oder ohne Einlagestoffe, gebildet werden.

Eine Weiterbildung ist dadurch gekennzeichnet, dass das Folienmaterial eine Dicke im Bereich von 10µm bis 3mm aufweist. Bevorzugt weist das Folienmaterial eine Dicke von 150µm auf.

Nach einer Weiterbildung ist ferner vorgesehen, dass die Tragstruktur mittels einer aushärtbaren Vergussmasse auf der Innenseite der Abdeckscheibe angeordnet ist, wobei die Leuchtmittel in Richtung der Abdeckscheibe ausgerichtet sind. Diese Weiterbildung hat den Vorteil, dass eine Vergussmasse die Tragstruktur mit den darauf angeordneten Leuchtmitteln umschließend aufnehmen kann. Da die Tragstruktur folienartig ausgebildet ist und somit eine inhärente Flexibilität aufweist, hat diese Weiterbildung den weiteren Vorteil, dass die Tragstruktur nach Aushärten der Vergussmasse, von dieser mechanisch fixiert und stabilisiert wird. Die Vergussmasse kann transparent oder diffus ausgebildet sein. Eine diffuse Vergussmasse hat den Vorteil, dass damit eine Lichtstreuung und somit eine gleichmäßige Verteilung des Lichts der Leuchtmittel erreicht wird. Nicht abschließende kann die Vergussmasse bspw. durch Polyimide, Epoxide, Methacrylate oder Polyurethan-Harze gebildet sein. Die Vergussmasse kann aber auch durch eine Spritzmasse aus PMMA, PA, PLA, ABS, PET, PE, PS, PEEK oder PVC, oder eine Schmelzmasse aus EVA gebildet sein.

Eine Weiterbildung besteht auch darin, dass das aushärtbare Verbindungsmaterial durch einen elektrisch leitfähigen Klebstoff gebildet ist. Ein derartiges Verbindungsmaterial erfüllt in vorteilhafter Weise zwei Anforderungen. Einerseits wird das Leuchtmittel aufgenommen und bis zum Aushärten soweit gehalten, das ein Versatz verhindert wird. Somit können die Leuchtmittel angeordnet werden und bleiben bis zum Aushärten des Verbindungsmaterials an ihrem Platz. Andererseits ist das Verbindungsmaterial gleichzeitig elektrisch leitfähig, sodass auch eine elektrische Kontaktierung des Leuchtmittels erfolgt.

Nach einer Weiterbildung ist ferner vorgesehen, dass die Leuchtmittel durch Leuchtdioden gebildet sind. Leuchtdioden haben gegenüber Glüh- bzw. Halogenlampen den besonderen Vorteil, dass sie einen deutlich höheren Wirkungsgrad aufweisen, kompakter sind und weniger Verlustwärme produzieren.

Eine Weiterbildung ist auch dadurch gekennzeichnet, dass mehrere Leuchtmittel zusammen ein Funktionslicht bilden. Da mit einem einzelnen Leuchtmittel unter Umständen weder die gewünschte bzw. geforderte Beleuchtungsstärke, noch die gewünschte bzw. geforderte Abstrahlcharakteristik erreicht werden kann, können gemäß dieser Weiterbildung mehrere Leuchtmittel zusammengefasst werden. Unter Funktionslicht werden bspw. ein Brems-, Abbiege-, Seit-, Rückfahr-, Rück- und/oder ein Begrenzungslicht verstanden.

Eine Weiterbildung, nach der auf der Tragstruktur aktive und/oder passive elektronische Komponenten angeordnet sind hat den Vorteil, dass die Ansteuerung der Leuchtmittel direkt in/von der Kraftfahrzeug-Außenleuchte erfolgt. Beispielsweise beim Abbiegeanzeiger ist ein regelmäßiges Blinken des Leuchtmittels oder ein Lauflicht erforderlich. Mit dieser Weiterbildung ist lediglich ein Steuersignal, bspw. das Anlegen der Versorgungsspannung erforderlich, um die gewünschte Funktion auszuführen. Externe Komponenten wie bspw. ein Blinker Relais sind somit nicht mehr erforderlich.

Gesetzliche Vorschriften schreiben bspw. eine spezifische Licht-Abgabecharakteristik vor, insbesondere sind Bereiche vorgegeben, in denen kein, oder nur abgeschwächtes Licht abgegeben werden darf. Daher ist nach einer Weiterbildung vorgesehen, dass die Tragstruktur und/oder die Abdeckscheibe, Lichtformungs- und/oder Lichtlenkelemente aufweist. Da Kraftfahrzeug-Außenleuchten meist ein sehr markantes Erscheinungsmerkmal eines Kraftfahrzeugs darstellen, können die Lichtformungs- und/oder Lichtlenkelemente aber auch als Designelemente ausgeführt sein. Da bei bekannten Kraftfahrzeug-Außenleuchten die zwangsläufig erforderliche Reflektor- bzw. Lichtlenkeinheit ein beträchtliches Volumen aufwies, wurde dies auch meist als Designelement zur Abgrenzung gegenüber dem Mitbewerb genommen. Da bei der gegenständlichen Kraftfahrzeug-Außenleuchte keine Reflektor- bzw. Lichtlenkeneinheit erforderlich ist, kann mit dieser Weiterbildung das Designelement wieder eingeführt werden, wobei aufgrund der platzsparenden Ausführung der gegenständlichen Kraftfahrzeug-Außenleuchte dennoch eine deutliche Platzreduktion gegenüber bekannten Kraftfahrzeug-Außenleuchten gegeben ist.

Da die Tragstruktur durch ein elastisch rückstellbares Folienmaterial gebildet ist und auf der Tragstruktur elektrisch leitfähige Strukturen angeordnet sind, kommt es bei einer Deformation der Tragstruktur unweigerlich auch zu einer Deformation der elektrisch leitfähigen Strukturen. Daher ist gemäß einer Weiterbildung vorgesehen, dass die elektrisch leitfähigen Strukturen abschnittsweise mäanderartig ausgebildet sind. Bei einer geradlinigen Struktur besteht bei einer auftretenden Deformation die Gefahr einer Beschädigung bzw. eines Bruchs. Eine mäanderförmige Struktur kann eine Deformation ausgleichen, wodurch eine Beschädigung verhindert wird.

Nach einer Weiterbildung ist ferner vorgesehen, dass die Tragstruktur einen elektrischen Kontaktabschnitt aufweist. Dies hat den Vorteil, dass die gesamte elektrische Kontaktierung der Kraftfahrzeug-Außenleuchte über diesen Kontaktabschnitt erfolgt. Bei bekannten Kraftfahrzeug-Außenleuchten waren zumeist mehrere Anschlussabschnitte vorhanden, was einerseits zu Mehrkosten führte und andererseits höhere Montage- und Servicekosten verursachte, insbesondere da auch der Kabelbaum im Kraftfahrzeug aufwändiger ausgeführt war.

Da die Leuchtmittel im Betrieb Abwärme produzieren, muss diese zur Einhaltung einer maximalen Betriebstemperatur abgeführt werden. Daher ist gemäß einer Weiterbildung vorgesehen, dass auf der Tragstruktur Wärme-Ableitungsabschnitte vorhanden sind. Beispielsweise können diese Ableitungsabschnitte auf der, der Abdeckscheibe abgewandten Flachseite der Tragstruktur angeordnet sein.

Eine Weiterbildung ist auch dadurch gekennzeichnet, dass die zusammengefügte Kraftfahrzeug-Außenleuchte eine größte Dicker kleiner 15mm aufweist. Als Dicke wird jene Abmessung verstanden, welche im Wesentlichen normal zur Innenseite der Abdeckscheibe gerichtet ist und durch die Dicke der Abdeckscheibe und der auf der Innenseite der Abdeckscheibe angeordneten Tragstruktur mit den darauf angeordneten Leuchtmittel gebildet ist. Zur Dicke zählen insbesondere nicht, eventuell erforderliche Montagestrukturen zur Anordnung der Kraftfahrzeug-Außenleuchte am Fahrzeug und allfällige zusätzliche Gehäuseteile.

Die Aufgabe der Erfindung wird auch durch ein Verfahren zur Herstellung einer Kraftfahrzeug-Außenleuchte nach Anspruch 10 gelöst. Dabei wird zur Bildung von elektrisch leitfähigen Strukturen, mittels eines ersten Druckverfahrens, auf einer Bestückungsseite des Folienmaterials eine leitfähige Druckpaste aufgebracht und die Druckpaste thermisch oder mittels Strahlung im optischen Frequenzbereich ausgehärtet. Mittels eines zweiten Druckverfahrens wird in Abschnitten der elektrischen Strukturen, ein aushärtbares elektrisch leitendes Verbindungmaterial aufgebracht. Mittels einer Positioniervorrichtung werden Leuchtmittel so aufgebracht, dass elektrische Anschlussabschnitte der Leuchtmittel selektiv in Kontakt mit dem elektrisch leitenden Verbindungsmaterial kommen. Das elektrisch leitende Verbindungsmaterial wird thermisch oder mittels Strahlung im optischen Frequenzbereich ausgehärtet. Auf die Innenseite der Abdeckscheibe wird eine aushärtbare Vergussmasse aufgebracht und die Tragstruktur mit den Leuchtmitteln in Richtung der Innenseite in die Vergussmasse eingelegt und die Vergussmasse thermisch oder mittels Strahlung im optischen Frequenzbereich ausgehärtet.

Auf der Tragstruktur sind elektrisch leitende Strukturen vorhanden, welche bevorzugt zur Versorgung der Leuchtmittel mit elektrischer Energie dienen. Um einen Stromfluss zu ermöglichen, wird jedes Leuchtmittel zumindest zwei Anschlüsse aufweisen, die mittels des elektrisch leitfähigen Verbindungsmittels in elektrisch leitfähigen Kontakt mit jeweils einer elektrisch leitfähigen Struktur gebracht werden. Nach Aushärten des Verbindungsmaterials ist das Leuchtmittel mechanisch fest auf der Tragstruktur fixiert und gleichzeitig elektrisch kontaktiert.

Nach einer Weiterbildung ist vorgesehen, dass nach dem Aushärten der Druckpaste auf diese eine weitere Lage eines Folienmaterials aufgebracht wird, und die Verfahrensschritte Aufbringen einer leitfähigen Druckpaste und Aushärten derselben, wiederholt werden. Mit dieser Weiterbildung wird es möglich, eine Mehrlagenstruktur zu bilden. Dies ist von Vorteil, wenn sich aufgrund von Platzbeschränkungen die Anordnung der elektrisch leitfähigen Strukturen schwierig gestaltet.

Eine Weiterbildung ist dadurch gekennzeichnet, dass als erstes oder zweites Druckverfahren eines der Gruppe Sieb-, Rollen-, Schablonen- und Inkjetdruck und Continous Flow Dispension verwendet wird.

Da die Abdeckscheibe einer Kraftfahrzeug-Außenleuchte zumeist nicht eben sein wird, ist es von Vorteil, wenn vor Einlegen der Tragstruktur in die Vergussmasse, die Tragstruktur umgeformt wird. Beispielsweise kann die Tragstruktur mit den darauf angeordneten Leuchtmitteln und ggf. weiteren Komponenten in einer Tiefziehvorrichtung an die Form der Abdeckscheibe angepasst werden. Wird eine folienartige Tragstruktur ohne Umformung an der Innenseite und somit an der Kontur der Abdeckscheibe angeordnet, kann es zu Faltenbildung und/oder Spannungen im Folienmaterial kommen. Beim Umformvorgang wird die Tragstruktur bevorzugt etwas erwärmt, so dass sich das Folienmaterial der Form des Umformwerkzeugs anpassen kann.

Zur Montage der Kraftfahrzeug-Außenleuchte am Fahrzeug ist nach einer Weiterbildung vorgesehen, dass auf die der Abdeckscheibe abgewandte Rückseite der Tragstruktur, eine Haltevorrichtung aufgebracht wird. Beispielsweise kann dies durch Anspritzen einer Haltevorrichtung im Spritzgußverfahren erfolgen. Hierzu sind dem Fachmann weitere Verfahren bekannt, um eine Haltevorrichtung an einem bestehenden Bauteil anzuformen.

Zum besseren Verständnis der Erfindung wird diese anhand der nachfolgenden Figuren näher erläutert.

Es zeigen jeweils in stark vereinfachter, schematischer Darstellung:
- Fig. 1: eine Kraftfahrzeug-Außenleuchte nach dem Stand der Technik;
- Fig. 2: einen Querschnitt durch die gegenständliche Kraftfahrzeug-Außenleuchte;
- Fig. 3: eine Draufsicht auf die Tragstruktur und die elektrisch leitfähigen Strukturen der gegenständlichen Kraftfahrzeug-Außenleuchte.

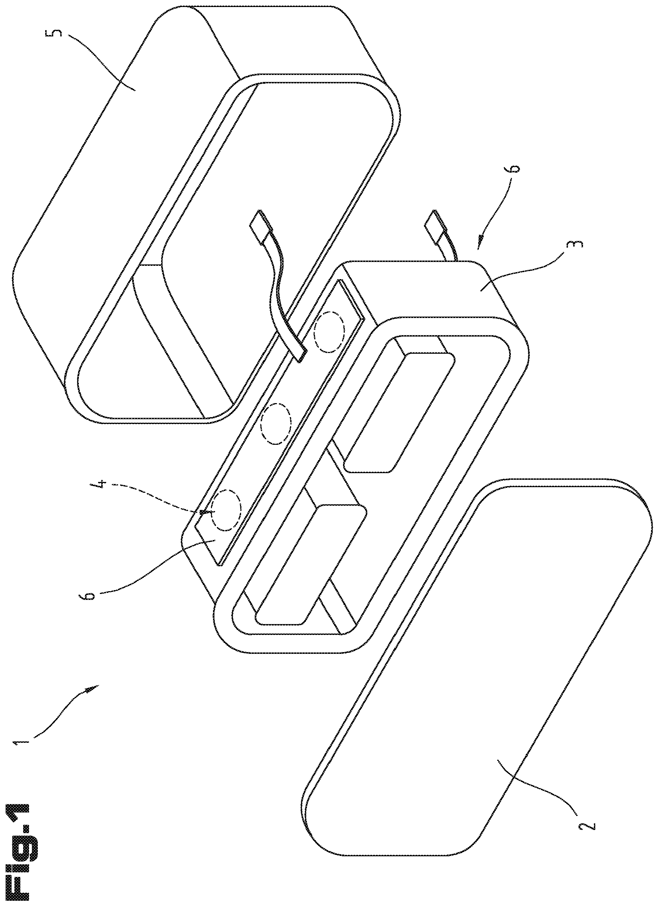

Fig. 1 zeigt eine Kraftfahrzeug-Außenleuchte 1 nach dem Stand der Technik. Die Kraftfahrzeug-Außenleuchte 1 umfasst eine Abdeckscheibe 2, eine Reflektor- und Lichtlenkeinheit 3 in welcher Leuchtmittel 4 angeordnet sind und ferner ein rückwärtiges Gehäuse 5. Zur Kraftfahrzeug-Außenleuchte 1 zusammengefügt, wird die Reflektor- und Lichtlenkeinheit 3 im Gehäuse 5 angeordnet und das Gehäuse 5 von der Abdeckscheibe 2 gegen die Umgebung verschlossen. Da die Reflektor- und Lichtlenkeinheit 3 zur Erfüllung der vorgesehenen Lichtlenkung eine respektable Tiefe aufweist, ergibt sich auch im zusammengebauten Zustand der Kraftfahrzeug-Außenleuchte 1 ein bedeutender Platzbedarf, um die Kraftfahrzeug-Außenleuchte 1 im Fahrzeug anzuordnen. Ferner sind an der Lichtlenkeinheit 3 noch elektrische Leitstrukturen 6 vorhanden, um die Leuchtmittel 4 über ein Anschlusskabel, welches durch die Gehäusewand 5 geführt werden muss, mit elektrischer Energie zu versorgen. Aufgrund der teils komplexen, geometrischen Struktur der Reflektor- und Lichtlenkeinheit 3 sind mehrere Leiterstrukturen 6 vorhanden, was einerseits den Herstellungsaufwand erhöht und zusätzlich einen größeren Aufwand beim elektrischen Anschluss der Kraftfahrzeug-Außenleuchte 1 mit sich bringt.

Bei einer Ausbildung als Frontscheinwerfer oder Rückleuchte, hat eine große Tiefe jedenfalls einen Nachteil. Im jeweiligen Einbaubereich eines Kraftfahrzeuges steht zumeist nur sehr wenig Platz zur Verfügung, womit jede Einsparung in der Einbautiefe von Vorteil ist.

Ein weiterer Nachteil der bekannten Ausführung liegt darin, dass aufgrund des komplexen und mehrteiligen Aufbaus, die Kraftfahrzeug-Außenleuchte 1 ein bedeutendes Gewicht aufweisen wird. Im Hinblick auf Energieeffizienz im Kraftfahrzeugbau ist man jedoch bestrebt, das gesamte Kraftfahrzeug möglichst leicht auszuführen, was bedeutet, dass auch jedes einzelne Bauteil des Kraftfahrzeugs möglichst leicht ausgeführt werden soll.

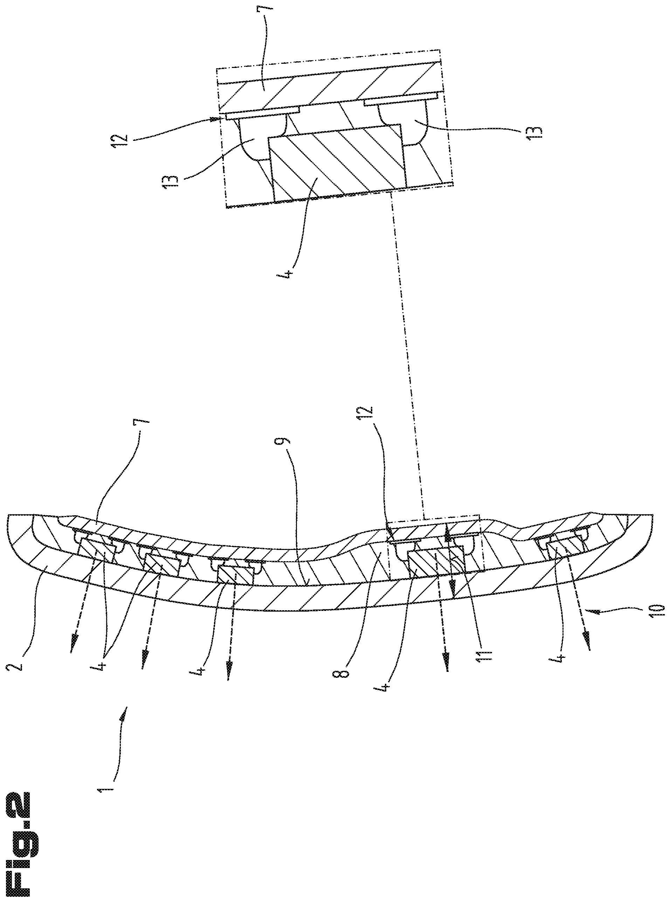

Fig. 2 zeigt nun eine Schnittdarstellung der gegenständlichen Kraftfahrzeug-Außenleuchte 1. Zu erkennen ist dabei, dass die Tragstruktur 7 zusammen mit den, auf der Tragstruktur 7 angeordneten Leuchtmitteln 4, mittels einer aushärtbaren Vergussmasse 8, auf der Innenseite 9 der Abdeckscheibe 2 angeordnet ist. Insbesondere ist die Tragstruktur 7 derart ausgerichtet, dass die Leuchtmittel 4 in Richtung der Innenseite 9 der Abdeckscheibe 2 angeordnet sind und somit ihr Licht durch die lichtdurchlässige Abdeckscheibe 2 in den Außenraum 10 abgeben.

Durch die vorteilhafte Verwendung einer flexiblen Tragstruktur 7 und direkte Anordnung der Tragstruktur 7 auf der Innenseite 9 der Abdeckscheibe 2 wird ein besonders kompakter Aufbau, insbesondere eine besonders geringe größte Dicke 11 der Kraftfahrzeug-Außenleuchte 1 erreicht.

Auf der, der Innenseite 9 der Abdeckscheibe 2 zugewandten Flachseite der Tragstruktur 7, sind elektrisch leitende Strukturen 12 angeordnet, wobei jeweils ein Leuchtmittel 4 mittels eines aushärtbaren Verbindungsmaterials 13 direkt auf der Tragstruktur 7 angeordnet ist. Bevorzugt ist das aushärtbare Verbindungsmaterial 13 elektrisch leitfähig ausgebildet. Dies hat den Vorteil, dass das Leuchtmittel 4 sowohl in seiner Position bzw. seiner Ausrichtung in Relation zur Tragstruktur 7 gehalten wird, als auch eine elektrische Kontaktierung des Leuchtmittels 4 mit der elektrisch leitfähigen Struktur 12 erfolgt. Aufgrund der hohen Arbeitstemperaturen bestünde bei Verwendung von Lötmitteln die Gefahr der thermischen Beschädigung der Tragstruktur 7.

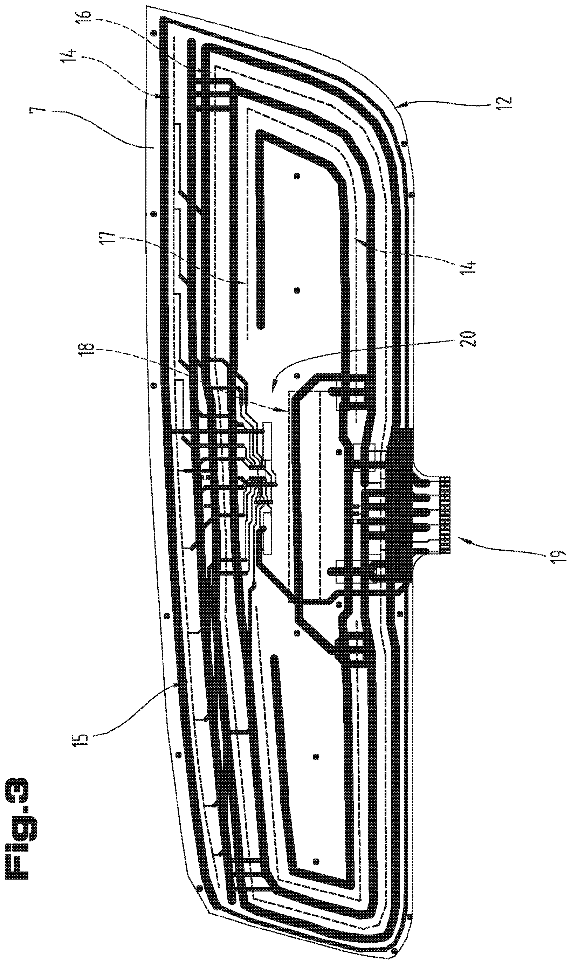

Fig. 3 zeigt eine Draufsicht auf die Tragstruktur 7 mit den darauf aufgebrachten, elektrisch leitfähigen Strukturen 12. Aus Vereinfachungsgründen sind die auf der Tragstruktur 7 angeordneten und mit der elektrisch leitfähigen Struktur 12 verbundenen Leuchtmittel im Detail nicht dargestellt. Anstelle der einzelnen Leuchtmittel wird das durch die Leuchtmittel gebildete Funktionslicht 14 dargestellt. Im Fall der in Fig. 3 dargestellten Kraftfahrzeug-Rückleuchte handelt es sich dabei um einen Fahrtrichtungsanzeiger 15, ein Begrenzungslicht 16, ein Bremslicht 17 sowie eine Rückfahrleuchte 18.

Zur Versorgung der einzelnen Funktionslichter 14 mit elektrischer Energie sind die elektrisch leitfähigen Strukturen 12 mit entsprechenden Kontakten in einem elektrischen Kontaktabschnitt 19 verbunden. Zur Verbindung der einzelnen Abschnitte der elektrisch leitfähigen Struktur 12 mit dem Kontaktabschnitt 19, insbesondere der innen liegenden elektrisch leitfähigen Strukturen, ist vorgesehen, dass die elektrisch leitfähige Struktur 12 mehrlagig, insbesondere zweilagig, ausgeführt ist. Um einen elektrischen Kurzschluss an den Kreuzungspunkten von sich überlagernden Leitstrukturen zu verhindern, ist zwischen den elektrischen Leitstrukturen eine elektrische Isolierschicht angeordnet.

Zur Ausbildung spezifischer, insbesondere vom Dauerlicht abweichender Lichteffekte ist ferner vorgesehen, dass auf der Tragstruktur 7 weitere aktive und/oder passive elektronische Komponenten 20 angeordnet sind. Mit diesen elektronischen Komponenten 20 wird beispielsweise erreicht, dass der Fahrtrichtungsanzeiger 15 das gewohnte Blinklicht abgibt bzw. durch eine spezifische, individuelle Ansteuerung der Leuchtmittel des Funktionslichts Fahrtrichtungsanzeiger 15, ein Helligkeitsverlauf in Form eines Lauflichtes erzeugt wird.

Der Vorteil der gegenständlichen Kraftfahrzeug-Außenleuchte liegt nun insbesondere darin, dass aufgrund der flexiblen und elastischen Tragstruktur 7, diese sich besonders gut der äußeren Form der Abdeckscheibe anpassen kann, sodass die auf der Tragstruktur 7 angeordneten Leuchtmittel 4 möglichst nahe an der Innenseite der Abdeckscheibe angeordnet sind. Somit wird einerseits eine deutliche Vereinfachung des Aufbaus erreicht, da die Leuchtmittel 4 mittels eines aushärtbaren Verbindungsmaterials direkt auf der Tragstruktur 7 angeordnet sind und mittels desselben aushärtbaren Verbindungsmaterials elektrisch mit der leitfähigen Struktur 12 verbunden sind. Die elastische Tragstruktur 7 gewährleistet nun die möglichst gute Positionierung der Leuchtmittel in Relation zur Abdeckscheibe bei gleichzeitigem, gutem Schutz der Leuchtmittel und einer zuverlässigen elektrischen Kontaktierung.

Im Gegensatz zu bekannten Kraftfahrzeug-Außenleuchten wird dadurch eine bedeutende Reduktion der Einbautiefe und damit des Einbaugewichts erreicht und gleichzeitig der Aufbau deutlich vereinfacht.

Abschließend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

Die Ausführungsbeispiele zeigen mögliche Ausführungsvarianten der Kraftfahrzeug-Außenleuchte, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Des Weiteren können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Vor allem können die einzelnen in den Fig. 2 und 3 gezeigten Ausführungen den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

Der Ordnung halber sei abschließend darauf hingewiesen, dass zum besseren Verständnis des Aufbaus der Kraftfahrzeug-Außenleuchte diese bzw. deren Bestandteile teilweise unmaßstäblich und/oder vergrößert und/oder verkleinert dargestellt wurden.

### Bezugszeichenaufstellung

- 1: Kraftfahrzeug-Außenleuchte
- 2: Abdeckscheibe
- 3: Reflektor- und Lichtlenkeinheit
- 4: Leuchtmittel
- 5: Gehäuse
- 6: Leiterstruktur
- 7: Tragstruktur
- 8: Vergussmasse
- 9: Innenseite
- 10: Lichtabgabe
- 11: Größte Dicke
- 12: elektrisch leitfähige Struktur
- 13: Verbindungsmaterial
- 14: Funktionslicht
- 15: Fahrtrichtungsanzeiger
- 16: Begrenzungslicht
- 17: Bremslicht
- 18: Rückfahrleuchte
- 19: Kontaktabschnitt
- 20: elektronische Komponenten

## Patentansprüche

1. Kraftfahrzeug-Außenleuchte (1), insbesondere zur Lichtabgabe in Richtung eines Abschnitts des Fahrwegs des Kraftfahrzeugs,
umfassend eine Tragstruktur (7), eine Mehrzahl von Leuchtmittel und eine zumindest abschnittsweise lichtdurchlässige Abdeckscheibe (2),
wobei auf der Tragstruktur (7) elektrisch leitfähige Strukturen (12) angeordnet sind, und wobei die Leuchtmittel die leitfähigen Strukturen (12) elektrisch kontaktierend, an der Tragstruktur (7) angeordnet sind, und
wobei die Abdeckscheibe (2) eine den Leuchtmittel (4) zugewandte Innenseite (9) aufweist, **dadurch gekennzeichnet, dass**
die Tragstruktur (7) durch ein elastisch rückstellbares Folienmaterial gebildet ist, welches Folienmaterial eine Kunststofffolie oder einen Verbundkunststoff ist, , und
wobei die Leuchtmittel (4) mittels eines aushärtbaren Verbindungsmaterials (13),einem elektrisch leitfähigen Klebstoff, direkt auf der Tragstruktur (7) angeordnet sind, und
wobei die Tragstruktur (7) in einer aushärtbaren Vergussmasse (8) auf der Innenseite (9) der Abdeckscheibe (2) angeordnet ist, sodass die Leuchtmittel in Richtung der Abdeckscheibe (2) ausgerichtet sind, und
dass ferner auf der Tragstruktur (7) aktive und passive elektronische Komponenten (20) angeordnet sind.

2. Kraftfahrzeug-Außenleuchte nach Anspruch 1, **dadurch gekennzeichnet, dass** das Folienmaterial eine Dicke im Bereich von 10µm bis 3mm aufweist.

3. Kraftfahrzeug-Außenleuchte nach einem der Ansprüche 1 oder 2, **dadurch gekennzeichnet, dass** die Leuchtmittel durch Leuchtdioden gebildet sind.

4. Kraftfahrzeug-Außenleuchte nach Anspruch 3, **dadurch gekennzeichnet, dass** mehrere Leuchtmittel (4) zusammen ein Funktionslicht (14) bilden.

5. Kraftfahrzeug-Außenleuchte nach einem der Ansprüche 1 bis 4, **dadurch gekennzeichnet, dass** die Tragstruktur (7) und/oder die Abdeckscheibe (2) Lichtformungs- und/oder Lichtlenkelemente aufweist.

6. Kraftfahrzeug-Außenleuchte nach einem der Ansprüche 1 bis 5, **dadurch gekennzeichnet, dass** die elektrisch leitfähigen Strukturen abschnittsweise mäanderartig ausgebildet sind.

7. Kraftfahrzeug-Außenleuchte nach einem der Ansprüche 1 bis 6, **dadurch gekennzeichnet, dass** die Tragstruktur (7) einen elektrischen Kontaktabschnitt (19) aufweist.

8. Kraftfahrzeug-Außenleuchte nach einem der Ansprüche 1 bis 7, **dadurch gekennzeichnet, dass** auf der Tragstruktur (7) Wärmeableitungsabschnitte vorhanden sind.

9. Kraftfahrzeug-Außenleuchte nach einem der Ansprüche 1 bis 8, **dadurch gekennzeichnet, dass** die zusammengefügte Kraftfahrzeug-Außenleuchte (1) eine größte Dicke (11) kleiner 15mm aufweist.

10. Verfahren zur Herstellung einer Kraftfahrzeug-Außenleuchte (1) nach einem der Ansprüche 1 bis 9, **dadurch gekennzeichnet, dass**
• zur Bildung von elektrisch leitfähigen Strukturen, mittels eines ersten Druckverfahrens auf einer Bestückungsseite des Folienmaterials, eine leitfähige Druckpaste aufgebracht wird;
• die Druckpaste thermisch oder mittels Strahlung im optischen Frequenzbereich ausgehärtet wird;
• mittels eines zweiten Druckverfahrens in Abschnitten der elektrischen Strukturen, ein aushärtbares elektrisch leitendes Verbindungmaterial aufgebracht wird;
• Leuchtmittel mittels einer Positioniervorrichtung so aufgebracht werden, dass elektrische Anschlussabschnitte der Leuchtmittel selektiv in Kontakt mit dem elektrisch leitenden Verbindungsmaterial (13) kommen;
• das elektrisch leitende Verbindungsmaterial (13) thermisch oder mittels Strahlung im optischen Frequenzbereich ausgehärtet wird;
• auf die Innenseite (9) der Abdeckscheibe (2) eine aushärtbare Vergussmasse (8) aufgebracht wird und die Tragstruktur (7) mit den Leuchtmittel in Richtung der Innenseite (9), in die Vergussmasse (8) eingelegt wird;
• das die Vergussmasse (8) thermisch oder mittels Strahlung im optischen Frequenzbereich ausgehärtet wird.

11. Verfahren nach Anspruch 10, **dadurch gekennzeichnet, dass** nach dem Aushärten der Druckpaste auf diese eine weitere Lage eines Folienmaterials aufgebracht wird, und die Verfahrensschritte Aufbringen einer leitfähigen Druckpaste und Aushärten derselben wiederholt werden.

12. Verfahren nach Anspruch 10 oder 11, **dadurch gekennzeichnet, dass** als erstes oder zweites Druckverfahren eines der Gruppe Sieb-, Rollen-, Schablonen- und Inkjetdruck und Continous Flow Dispension verwendet wird.

13. Verfahren nach einem der Ansprüche 10 bis 12, **dadurch gekennzeichnet, dass** vor Einlegen der Tragstruktur (7) in die Vergussmasse (8), die Tragstruktur (7) umgeformt wird.

14. Verfahren nach Anspruch 10 bis 13, **dadurch gekennzeichnet, dass** auf die der Abdeckscheibe (2) abgewandte Rückseite der Tragstruktur (7), eine Haltevorrichtung aufgebracht wird.

## Claims

1. A motor vehicle exterior light (1), in particular for emitting light in the direction of a section of the travel path of the motor vehicle,
comprising a support structure (7), a plurality of lighting means and a cover disk (2) which is light-transmissive at least in sections,
wherein electrically conductive structures (12) are arranged on the support structure (7), and
wherein the lighting means in electrical contact with the conductive structures (12) are arranged on the support structure (7), and
wherein the cover disk (2) has an inner side (9) facing the lighting means (4), **characterised in that**
the support structure (7) is formed by an elastically resettable film material, which film material is a plastic film or a composite plastic, and
wherein the lighting means (4) are arranged directly on the support structure (7) by means of a curable connecting material (13), an electrically conductive adhesive, and wherein the support structure (7) is arranged on the inner side (9) of the cover disk (2) in a curable casting compound (8), so that the lighting means are oriented in the direction of the cover disk (2), and
**in that** active and passive electronic components (20) are also arranged on the support structure (7).

2. The motor vehicle exterior light according to claim 1, **characterised in that** the film material has a thickness in the range of 10µm to 3mm.

3. The motor vehicle exterior light according to any one of claims 1 or 2, **characterised in that** the lighting means are formed by lighting diodes.

4. The motor vehicle exterior light according to claim 3, **characterised in that** a plurality of lighting means (4) together form a functional light (14).

5. The motor vehicle exterior light according to any one of claims 1 to 4, **characterised in that** the support structure (7) and/or the cover disk (2) have/has light-shaping and/or light-guiding elements.

6. The motor vehicle exterior light according to any one of claims 1 to 5, **characterised in that** the electrically conductive structures are formed in a meandering manner in sections.

7. The motor vehicle exterior light according to any one of claims 1 to 6, **characterised in that** the support structure (7) has an electrical contact section (19).

8. The motor vehicle exterior light according to any one of claims 1 to 7, **characterised in that** heat-dissipating sections are present on the support structure (7).

9. The motor vehicle exterior light according to any one of claims 1 to 8, **characterised in that** the assembled motor vehicle exterior light (1) has a maximum thickness (11) less than 15mm.

10. Method for producing a motor vehicle exterior light (1) according to any one of claims 1 to 9, **characterised in that**
• for forming electrically conductive structures, a conductive printing paste is applied by means of a first printing method to a mounting side of the film material;
• the printing paste is cured thermally or by means of radiation in the optical frequency range;
• a curable electrically conductive connecting material is applied by means of a second printing method in sections of the electrical structures;
• lighting means are applied by means of a positioning device so that electrical connection sections of the lighting means come into selective contact with the electrically conductive connecting material (13);
• the electrically conductive connecting material (13) is cured thermally or by means of radiation in the optical frequency range;
• a curable casting compound (8) is applied to the inner side (9) of the cover disk (2) and the support structure (7) with the lighting means is inserted in the casting compound (8) in the direction of the inner side (9);
• the casting compound (8) is cured thermally or by means of radiation in the optical frequency range.

11. The method according to claim 10, **characterised in that** after the curing of the printing paste a further layer of a film material is applied to this and the method steps are repeated by applying a conductive printing paste and curing the same.

12. The method according to claim 10 or 11, **characterised in that** one from the group of screen, roll, stencil and inkjet printing is used as the first or second printing method.

13. The method according to claims 10 to 12, **characterised in that** prior to insertion of the support structure (7) into the casting compound (8) the support structure (7) is reshaped.

14. The method according to claims 10 to 13, **characterised in that** a holding device is applied to the rear side of the support structure (7) facing away from the cover disk (2).

## Revendications

1. Eclairage extérieur de véhicule automobile (1), en particulier pour émettre de la lumière en direction d'une section du trajet du véhicule à moteur, comprenant une structure de support (7), plusieurs moyens d'éclairage et un une vitre de recouvrement au moins partiellement translucide (2),
dans lequel des structures électriquement conductrices (12) sont agencées sur la structure de support (7) et dans lequel les moyens d'éclairage en contact électrique avec les structures conductrices (12) sont agencées sur la structure de support (7), et
dans lequel la vitre de recouvrement (2) a une face intérieure (9) faisant face au moyen d'éclairage (4), **caractérisé en ce que** la structure de support (7) est constituée d'un matériau en feuille récupérable élastiquement, et
dans lequel les moyens d'éclairage (4) sont agencés directement sur la structure de support (7) au moyen d'un matériau de liaison durcissable (13), d'un adhésif électriquement conducteur, et dans lequel la structure de support (7) est agencée dans un composé d'enrobage durcissable (8) sur la face intérieure (9) de la vitre de recouvrement (2) de sorte que les moyens d'éclairage sont alignés dans la direction de la vitre de recouvrement (2), et en outre, que des composants électroniques actifs et passifs (20) soient disposés sur la structure de support (7).

2. Eclairage extérieur de véhicule automobile selon la revendication 1, **caractérisé en ce que** le matériau en feuille présente une épaisseur dans la zone comprise entre 10µm et 3mm.

3. Eclairage extérieur de véhicule automobile selon l'une des revendications 1 ou 2, **caractérisé en ce que** les moyens d'éclairage sont formés par des diodes électroluminescentes.

4. Eclairage extérieur de véhicule automobile selon la revendication 3, **caractérisé en ce que** plusieurs moyens d'éclairage (4) forment ensemble un éclairage fonctionnel (14).

5. Eclairage extérieur de véhicule automobile selon l'une des revendications 1 à 4, caractérisé en e que la structure de support (7) et/ou la vitre de recouvrement (2) comportent des éléments de mise en forme de la lumière et/ou de guidage de la lumière.

6. Eclairage extérieur de véhicule automobile selon l'une des revendications 1 à 5, **caractérisé en ce que** les structures électriquement conductrices sont formées en sections sinueuses.

7. Eclairage extérieur de véhicule automobile selon l'une des revendications 1 à 6, **caractérisé en ce que** la structure de support (7) présente une section de contact électrique (19).

8. Eclairage extérieur de véhicule automobile selon l'une des revendications 1 à 7, **caractérisé en ce que** des sections de dissipation de chaleur sont présentes sur la structure de support (7).

9. Eclairage extérieur de véhicule automobile selon l'une des revendications 1 à 8, **caractérisé en ce que** l'éclairage extérieur de véhicule automobile assemblé (1) présente une épaisseur maximale (11) inférieure à 15 mm.

10. Procédé de fabrication d'un éclairage extérieur de véhicule automobile (1) selon l'une des revendications 1 à 9, **caractérisé en ce que**
• pour la formation de structures électriquement conductrices, une pâte d'impression conductrice est appliquée au moyen d'un premier procédé d'impression sur un côté composant du matériau en feuille;
• la pâte d'impression est durcie thermiquement ou au moyen d'un rayonnement dans la plage de fréquence optique;
• au moyen d'un second procédé d'impression dans des sections des structures électriques, appliquer un matériau de liaison électriquement conducteur durcissable;
• des moyens d'éclairage sont appliqués au moyen d'un dispositif de positionnement de sorte que des sections de connexion électrique des moyens d'éclairage viennent sélectivement en contact avec le matériau de connexion électriquement conducteur (13);
• le matériau de connexion électriquement conducteur (13) est durci thermiquement ou au moyen d'un rayonnement dans la plage de fréquence optique;
• un composé d'enrobage durcissable (8) est appliqué sur la face intérieure (9) de la vitre de recouvrement (2), et la structure de support (7) est insérée avec les moyens d'éclairage vers l'intérieur (9) dans le composé d'enrobage (8);
• le composé d'enrobage (8) est durci thermiquement ou par rayonnement dans la gamme de fréquences optiques.

11. Procédé selon la revendication 10, **caractérisé en ce qu'**après le durcissement de la pâte d'impression sur celle-ci, une autre couche d'un matériau en feuille est appliquée et les étapes du procédé application d'une pâte d'impression conductrice et son durcissement sont répétées.

12. Procédé selon la revendication 10 ou 11, **caractérisé en ce que**, en tant que premier ou deuxième procédé d'impression, on utilise une impression du groupe sérigraphie, impression en rouleau, en stencil et à jet d'encre et Continous Flow Dispension (dispersion en flux continu).

13. Procédé selon l'une des revendications 10 à 12, **caractérisé en ce que** la structure de support (7) est formée avant l'insertion de la structure de support (7) dans le composé d'enrobage (8).

14. Procédé selon les revendications 10 à 13, **caractérisé en ce qu'**un dispositif de maintien est appliqué à l'arrière de la structure de support (7) opposée à la vitre de recouvrement (2).
